(19) Europäisches Patentamt
European Patent Office
Office européen des brevets

(11) **EP 3 973 090 B1**

(12) **EUROPÄISCHE PATENTSCHRIFT**

(45) Veröffentlichungstag und Bekanntmachung des Hinweises auf die Patenterteilung:
**01.04.2026 Patentblatt 2026/14**

(21) Anmeldenummer: **20723354.5**

(22) Anmeldetag: **30.04.2020**

(51) Internationale Patentklassifikation (IPC):
**C30B 29/06** (2006.01) **C30B 33/02** (2006.01)
**H01L 21/66** (2006.01)

(52) Gemeinsame Patentklassifikation (CPC):
**C30B 29/06; C30B 33/02; H10P 74/23;**
H10P 74/203

(86) Internationale Anmeldenummer:
**PCT/EP2020/061992**

(87) Internationale Veröffentlichungsnummer:
**WO 2020/233960 (26.11.2020 Gazette 2020/48)**

(54) **VERFAHREN ZUR HERSTELLUNG VON HALBLEITERSCHEIBEN**

METHOD FOR PRODUCING SEMICONDUCTOR WAFERS

PROCÉDÉ POUR LA FABRICATION DE PLAQUETTES SEMI-CONDUCTRICES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.05.2019 DE 102019207433**

(43) Veröffentlichungstag der Anmeldung:
**30.03.2022 Patentblatt 2022/13**

(73) Patentinhaber: **Siltronic AG**
**81677 München (DE)**

(72) Erfinder:
• **BOY, Michael**
**83329 Waging am See (DE)**
• **KÖSTER, Ludwig**
**84489 Burghausen (DE)**
• **SOYKA, Elena**
**84547 Emmerting (DE)**
• **STORCK, Peter**
**84489 Burghausen (DE)**

(56) Entgegenhaltungen:
**JP-A- 2015 073 049    US-A1- 2004 040 632**

• **MEZHENNYI M V ET AL: "Simulation of the stresses produced in large-diameter silicon wafers during thermal annealing", PHYSICS OF THE SOLID STATE, NAUKA/INTERPERIODICA, MO, vol. 45, no. 10, 1 October 2003 (2003-10-01), pages 1884 - 1889, XP019310943, ISSN: 1090-6460**
• **GEILER H D ET AL: "Photoelastic stress evaluation and defect monitoring in 300-mm-wafer manufacturing", MATERIALS SCIENCE IN SEMICONDUCTOR PROCESSING, ELSEVIER SCIENCE PUBLISHERS B.V., BARKING, UK, vol. 5, no. 4-5, 1 August 2002 (2002-08-01), pages 445 - 455, XP004417765, ISSN: 1369-8001, DOI: 10.1016/S1369-8001(02)00138-5**

EP 3 973 090 B1

**Beschreibung**

Die vorliegende Erfindung betrifft ein Verfahren zur Herstellung von Halbleiterscheiben, insbesondere die Testung von Kristallstücken auf Eignung im Bauelementprozess.

Monokristalline Halbleiterscheiben (auch Wafer genannt) sind die Grundlage der modernen Elektronik. Während der Herstellung von Bauelementen auf besagten Halbleiterscheiben werden thermische Prozesse mit mittlerweile recht komplexen Beschichtungsschritten durchgeführt. Dass es hierbei zu thermischen Spannungen (nachfolgend Stress genannt) im Kristallgitter führen kann, ist nicht weiter verwunderlich. Auch eine ungünstige Lagerung der Halbleiterwafer während der thermischen Behandlung der Halbleiterscheiben kann zu zusätzlichem Stress führen und schließlich kann, neben anderen Gründen, auch eine Beschichtung der Halbleiterscheiben zusätzliche Stressfelder hervorrufen.

Der sogenannte Upper Yield Stress $\tau_{uy}$ ist derjenige Materialparameter der Halbleiterscheibe, der angibt, ab welchem Stressniveau die Halbleiterscheibe nicht mehr elastisch reversibel, sondern plastisch irreversibel verformt wird. Der Upper Yield Stress der einzelnen Halbleiterscheibe hängt von vielen Parametern ab, die für den Einzelfall nicht oder nur teilweise zugänglich bzw. bekannt sind.

Ist der induzierte Stress größer als der jeweilige Upper Yield Stress, kann er durch irreversible Verformungen u.a. durch die Bildung von Vergleitungen (sogen. slip lines) abgebaut werden, die während des Bauelementeprozesses zu Ausfällen und damit zu erhöhten Kosten seitens der Hersteller von Bauelementen führen können.

Monokristalline Halbleiterscheiben, insbesondere Halbleiterscheiben aus Silicium, werden üblicherweise hergestellt, indem zuerst ein monokristalliner Stab mit Hilfe des sogenannten Float Zone Verfahrens (FZ) oder des Czochralski Verfahrens (CZ) gezogen wird. Die so produzierten Stäbe werden in Kristallstücke geteilt, welche üblicherweise in einer Drahtsäge oder Innenlochsäge zu Halbleiterscheiben verarbeitet werden. Nach dem Schleifen, Polieren und der Kantenbearbeitung kann optional eine Epischicht mittels CVD aufgebracht werden. Diese so hergestellten Halbleiterscheiben werden danach dem weiteren Bauelementprozess zur Verfügung gestellt.

Wird erst bei der thermischen Behandlung der Halbleiterscheibe im Bauelementprozess erkannt, dass die Halbleiterscheibe vergleitet, können je nach jeweiliger Fertigungstiefe erhebliche Kosten auftreten.

Aus diesem Grund besteht ein Bedürfnis, nur Halbleiterscheiben in den Bauelementprozess zu geben, bei denen der beim Bauelementprozess auftretende Stress kleiner ist als der Upper Yield Stress, und es daher nicht zur Ausbildung von Vergleitungen und somit zu Fehlern kommt.

In der Praxis sind weder der Upper Yield Stress der jeweiligen Halbleiterscheibe noch der beim Bauelementprozess auftretende Stress hinreichend bekannt.

Der in der Halbleiterscheibe während eines thermischen Schrittes auftretende Stress kann prinzipiell reduziert werden. Zum Beispiel lehrt US 2007/084827 A1, dass sich ein Suszeptor mit einer besonders kleinen Oberflächenrauigkeit, auf dem die Halbleiterscheibe abgelegt wird, während sie thermisch behandelt wird, dazu geeignet ist, die Anzahl der auftretenden Vergleitungen zu reduzieren. Diese Maßnahme verhindert im Allgemeinen jedoch nicht, dass der thermisch induzierte Stress beispielsweise verursacht durch sehr hohe Aufheiz- und Abkühlraten reduziert wird. In der Praxis sind hohe Aufheiz- und Abkühlraten üblich, da hohe Durchsätze die zur Verfügung stehende Zeit limitieren.

In US 2004/040632 A1 wird ein besonderer Suszeptor beschrieben, der eine ebene Auflagefläche für Halbleiterscheiben zur Behandlung bei hohen Temperaturen zur Verfügung stellt. Dieser Suszeptor erscheint geeignet zu sein, mechanisch bedingte Spannungen der Halbleiterscheiben bei der Behandlung zu reduzieren. Auch hier werden thermisch bedingte Spannungen nicht reduziert.

Die JP 2015 073049 A beschreibt ein Verfahren zur Bewertung von Siliziumwafern mithilfe eines SIRD-Geräts, das Infrarotlicht nutzt. Ziel ist es, die innere Spannung der Wafer zu messen, bevor sie sich durch thermische Belastung verformen. Das Verfahren entfernt kurzperiodische Komponenten aus dem Depolarisationswert und bewertet die langperiodischen Komponenten, um die Verschiebung der Musterpositionen vorherzusagen.

Sowohl der Upper Yield Stress einer Halbleiterscheibe als auch der tatsächlich induzierte Stress der Halbleiterscheibe im Bauelementprozess lassen sich nur sehr schwer vorhersagen. Damit einhergehend lässt sich auch sehr schwer vorhersagen, ob eine Halbleiterscheibe im Bauelementprozess Schaden nimmt oder nicht.

Deshalb ist es eine erste Aufgabe der vorliegenden Erfindung, ein Verfahren zum Bewerten von Halbleitermaterial eines Halbleiter-Wafers zu schaffen, das einen Hinweis darüber liefern kann, ob die gefertigten Halbleiterscheiben Erzeugung eines Schadens durch Vergleiten im Bauelementprozess Schaden nehmen oder nicht.

Eine zweite Aufgabe der vorliegenden Erfindung ist es, ein Verfahren zum Bewerten eines Halbleiter-Wafers zu schaffen, das die Größe und die Richtung einer Restspannung eines Wafers bestimmen kann.

Gelöst werden die Aufgaben durch die Merkmale der Ansprüche.

Bevorzugte Ausführungsformen des erfindungsgemäßen Verfahrens sind in der nachfolgenden Beschreibung detailliert beschrieben. Die einzelnen Merkmale können entweder separat oder in Kombination als Ausführungsformen der Erfindung verwirklicht werden.

Die Erfindung geht von einem nach dem Stand der Technik gezogenen Einkristall (Stab, Ingot) aus Silicium aus, der zunächst in Kristallstücke mittels einer Säge, bevorzugt einer Bandsäge, geschnitten wird.

Für die Erfindung kann der Einkristall auch aus einem anderen Halbleitermaterial wie zum Beispiel Germanium, Galliumarsenid, Galliumnitrid oder Mischungen daraus bestehen. Ferner können für die Erfindung neben dem Kristallziehverfahren nach Czochralski auch andere Kristallzüchtungsverfahren wir zum Beispiel Float Zone (FZ) verwendet werden.

Von einem Kristallstück wird bevorzugt mindestens eine Halbleiterscheibe als Testscheibe mit einer Bandsäge oder Innenlochsäge abgeschnitten und der erfindungsgemäßen Untersuchung zugeführt. Das zugehörige restliche Kristallstück wird entsprechend des Ergebnisses der Untersuchung dem weiteren Herstellungsverfahren für Halbleiterscheiben zugeführt.

Das weitere Herstellungsverfahren für Halbleiterscheiben beinhaltet die Schritte Drahtsägen, Schleifen, Läppen, Polieren, Kantenverrunden, Reinigen, Ätzen. Das Aufbringen einer homo- oder hetero-epitaktisch abgeschiedenen Schicht aus weiterem Halbleitermaterial ist optional.

Bei den von einem Einkristall abgetrennten Halbleiterscheiben aus Halbleitermaterial handelt es sich vorzugweise um eine monokristalline Siliciumscheibe mit einem Durchmesser von 150 mm, 200 mm oder bevorzugt 300 mm.

Eine Halbleiterscheibe umfasst eine Vorderseite und eine Rückseite sowie eine umlaufende Kante, die zusammen die Oberfläche dieser Scheibe bilden. Die Kante besteht in der Regel aus zwei durch vorangegangene Schleif- und Ätzprozesse abgeflachte Flächen, den sog. Facetten, und einer umlaufenden, senkrecht zu der Vorder- bzw. Rückseite der Scheibe stehenden Fläche, den sog. Apex oder Blunt. Die Vorderseite der Scheibe aus Halbleitermaterial ist definitionsgemäß diejenige Seite, auf der in nachfolgenden Bauelementprozess die gewünschten Mikrostrukturen aufgebracht werden.

Die so gewonnene Halbleiterscheibe wird erfindungsgemäß einer ersten thermischen Behandlung unterworfen, wobei das thermische Budget dieser thermischen Behandlung bevorzugt der thermischen Behandlung im Bauelementprozess entspricht. Es ist für die Erfindung unerheblich, ob dieser erste Schritt durchgeführt wird. Die Erfinder haben jedoch erkannt, dass die Durchführung dieses Schrittes die Messergebnisse deutlich verbessert.

Im Bauelementprozess werden üblicherweise thermische Behandlungsschritte durchgeführt, um zum Beispiel Beschichtungen aufzubringen. Je nach Art der Beschichtung sind unterschiedliche thermische Bedingungen wie Temperatur und Zeit (thermisches Budget) und unterschiedliche Gaszusammensetzungen (Ambient) nötig. Es zeigte sich, dass es für das erfindungsgemäße Verfahren unerheblich ist, ob bei der thermischen Behandlung eine Schicht abgeschieden wird oder nicht. Es reicht offenbar aus, das wesentliche Zeit-Temperatur-Profil (thermisches Budget) während des Bauelementprozesses nachzuahmen.

Ein solcher Bauelementprozess kann beispielsweise der sogenannte Toshiba-Test (3 h bei 780°C, anschließend 16 h bei 1000°C) sein. Es können jedoch auch andere thermische Schritte verwendet werden.

Verwendet man zusätzlich im ersten thermischen Behandlungsschritt bevorzugt die Atmosphäre, die im Bauelementprozess hauptsächlich verwendet wird, verbessern sich die Ergebnisse des erfindungsgemäßen Verfahrens nochmal deutlich. Die Atmosphäre enthält dabei bevorzugt ein oder mehrere Gase aus der Gruppe von Gasen He, Ar, $H_2$, $O_2$, $N_2$, $NH_3$, $SiHCl_3$, $SiH_2Cl_2$, $SiH_4$, $SiCl_4$, $CH_4Cl_2Si$, $CH_4$ oder $H_2O$.

Der zweite thermische Behandlungsprozess beinhaltet eine Aufheizphase, eine Haltephase und eine Abkühlphase. Die Aufheizphase ist die Phase, in der die Halbleiterscheibe von Raumtemperatur auf die gewünschte Temperatur $T_h$ der Haltephase (Haltetemperatur) erhitzt wird.

Als Aufheizrate wird der Quotient aus der Temperaturdifferenz zwischen Raumtemperatur und Temperatur in der Haltephase und der dafür benötigten Zeit des Aufheizens verstanden.

Ferner wird als Abkühlrate der Quotient aus der Temperaturdifferenz zwischen der Temperatur in der Haltephase und der Raumtemperatur und der dafür benötigten Zeit des Abkühlens verstanden.

Besonders bevorzugt wird eine Abkühlrate von maximal 4 K/s eingestellt. Die bevorzugte Aufheizrate beträgt bevorzugt maximal 3 K/s.

Der zweite thermische Behandlungsprozess wird erfindungsgemäß so durchgeführt, dass in der Haltephase eine Temperaturdifferenz auf der Halbleiterscheibe induziert wird. Diese Temperaturdifferenz wird dabei als Temperaturgradient vom Zentrum zum Rand der Halbleiterscheibe und die mittlere Temperatur der Halbleiterscheibe wird dabei als Haltetemperatur verstanden.

Bevorzugt ist eine Haltetemperatur zwischen 700°C und 1410°C (besonders bevorzugt zwischen 900°C und 1100°C) einzustellen. Die Haltezeit kann zwischen 10 Sekunden und 10 Minuten variieren, bevorzugte Haltezeit ist ca. 60 s.

Erfindungsgemäß beträgt der Betrag des Temperaturgradienten in der Haltephase zwischen 1 und 30 K und bevorzugt zwischen 2 und 5 K.

Ganz besonders bevorzugt ist der Betrag des Temperaturgradienten in der Haltephase sowohl höher als in der Aufheiz- als auch höher als in der Abkühlphase.

Dem Fachmann sind dabei mehrere Methoden bekannt, um den Temperaturgradienten zu messen. So kann zum Beispiel mit einem oder mehreren Pyrometern die Temperaturdifferenz an verschiedenen Stellen des heißen Wafers direkt bestimmt werden. Genauer jedoch lässt sich der eingestellte Temperaturgradient indirekt bestimmen, indem eine Beschichtung eines Wafers zum Beispiel mit SiHCl₃ durchgeführt wird. Die Abscheidung wird dabei reaktionslimitiert geführt, so dass die Abscheiderate eine starke Funktion der Temperatur ist. Nach Messung der Schichtdicke der abgeschiedenen Schicht (zum Beispiel mit Hilfe der Ellipsometrie) und der Verwendung geeigneter Kalibrierkurven kann die Temperatur an jedem Punkt des Wafers einer Temperatur zugeordnet und damit der radiale Temperaturgradient bestimmt werden.

Stressfelder sind lokale oder auch globale Verspannungen im Kristallgitter, die durch geeignete Verfahren, wie z.B. SIRD (Scanning Infrared Depolarisation) nachgewiesen werden können. SIRD nutzt das physikalische Prinzip, dass linear polarisiertes Licht in der Polarisationsrichtung verändert wird, wenn es durch einen Bereich fällt, der unter mechanischem Stress steht. Die Depolarisation wird dabei definiert als

$$D = 1 - \frac{I_p - I_o}{I_p + I_o}$$

wobei $I_p$ für die Intensität des Laserlichtes steht, das im Detektor aufgefangen wird und entsprechend der ursprünglichen Polarisationsrichtung (also parallel) polarisiert wird. $I_o$ steht für die Intensität des Laserlichtes, das im Detektor orthogonal zur ursprünglichen Polarisationsrichtung aufgefangen wird. Der Depolarisationsgrad D gilt hierbei als ein Maß für den Stress in der Halbleiterscheibe am gemessenen Ort.

Bevorzugt wird für die Messung der Spannung in der Testscheibe die Messmethode SIRD verwendet.

Bevorzugt wird auf Positionen eines vorher definierten Gebietes der Halbleiterscheibe der Depolarisationsgrad gemessen, um positionsbezogene Messwerte zu erhalten.

Die so erhaltenen positionsbezogenen Messwerte werden einem Hochpassfilter mit einer Grenzwellenlänge von 2 mm unterzogen.

Anschließend wird die Standardabweichung dieser positionsbezogenen Messwerte $\overline{s}$ nach

$$\overline{s} := \sqrt{\frac{1}{n} \sum_{i=1}^{n} (x_i - \overline{x})^2}$$

berechnet, wobei n für die Anzahl der Messungen, $x_i$ für den einzelnen Messwert an der Position i und $\overline{x}$ für den arithmetischen Mittelwert aller Messwerte in besagtem Gebiet steht.

Bevorzugt wird in einer ersten Rechenmethode ein Gebiet als radialsymmetrischer Ring auf dem Wafer definiert, dessen Mittelpunkt mit dem Mittelpunkt auf der Oberfläche des Wafers übereinstimmt. Der äußere Radius des Gebiets ist dabei kleiner als der Radius des Wafers, bevorzugt kleiner als 98% des Radius des Wafers, und der innere Radius ist größer als 50% des Radius des Wafers, bevorzugt größer als 75% des Radius des Wafers.

Der so ermittelte Parameter $\overline{s}$ wird dabei als erstes Maß der Robustheit des Wafers bezüglich eines thermischen Verfahrensschrittes bei der Bauelementherstellung verstanden.

Beispielsweise können mit der Anwendung der ersten Rechenmethode Kristallstücke von unterschiedlichen Kristallstücken von unterschiedlichen Kristallen untersucht werden, deren Herstellverfahren sich unterscheidet. Es können so Parameter des Kristallziehens in geeigneter Weise modifiziert werden, um der Robustheit der Halbleiterscheiben auf Stress zu erfüllen.

In einer zweiten Rechenmethode werden die mit dem Hochpassfilter bearbeiteten Messdaten in mindestens zwei Gebiete eingeteilt. Innerhalb des Gebietes wird sowohl nach dem Maximalwert als auch nach dem Minimalwert des Messwertes gesucht. Ist dabei der Maximalwert größer als ein vorher definierter Diskriminatorwert DU und der Minimalwert kleiner als der negative Wert des Diskriminatorwerts DU, so wird das Gebiet als "schlecht" bezeichnet, andernfalls als "gut".

Als Maß für die Stressanfälligkeit der Halbleiterscheibe für die Qualität des Wafers bezüglich der thermischen Behandlung wird in diesem zweiten Verfahren der Anteil der guten Gebiete in Verhältnis zu allen Gebieten verstanden.

Beispielsweise können mit der Anwendung der zweiten Rechenmethode Bereiche identifiziert bzw. beobachtet werden, die in der Robustheit bzgl. Stress anfällig sind.

**Patentansprüche**

1. Verfahren zum Bewerten von Halbleiterscheiben, wobei

ein einkristalliner Stab aus Silicium bereitgestellt wird,
der Stab in Kristallstücke geschnitten und von einem Kristallstück eine Testscheibe abgetrennt wird,
wobei die Testscheibe einem ersten thermischen Behandlungsverfahren unterworfen wird und
danach ein zweites thermisches Behandlungsverfahren erfolgt,
das eine Aufheizphase, eine Haltephase bei Haltetemperatur $T_h$ und einer Abkühlphase beinhaltet
und das eine radiale Temperaturdifferenz zwischen Zentrum und Rand $\Delta T$ auf der Testscheibe verursacht,
und nach Abkühlung der Testscheibe eine Untersuchung der Scheibe aus Halbleitermaterial hinsichtlich Stressfeldern erfolgt, wobei eine SIRD Messung verwendet wird, und das Ergebnis dazu benutzt wird, um zu entscheiden, ob die Halbleiterscheiben gewonnen aus dem Kristallstück für den Bauelementprozess verwendet werden oder nicht, wobei der Betrag Temperaturdifferenz zwischen Zentrum und Rand der Testscheibe in der Haltephase zwischen 1 K und 30 K beträgt.

2. Verfahren nach Anspruch 1, **dadurch gekennzeichnet, dass** die Temperatur der Haltephase $T_h$ zwischen 700°C und 1410°C bevorzugt zwischen 900°C und 1100°C liegt.

3. Verfahren nach einem der vorigen Ansprüche, **dadurch gekennzeichnet, dass** der einkristalline Stab nach dem Czochralski Verfahren gezogen wird.

4. Verfahren nach einem der vorigen Ansprüche, **dadurch gekennzeichnet, dass** der einkristalline Stab nach dem Float Zone Verfahren gezogen wird.

5. Verfahren nach einem der vorigen Ansprüche, **dadurch gekennzeichnet, dass**

   die Aufheizrate der Aufheizphase kleiner ist als 4 K/s und
   die Abkühlrate der Abkühlphase kleiner ist als 5 K/s.

6. Verfahren nach einem der vorigen Ansprüche, **dadurch gekennzeichnet, dass** der Betrag der Temperaturdifferenz zwischen Zentrum und Rand der Testscheibe in der Haltephase zwischen 2 K und 5 K beträgt.

7. Verfahren nach einem der vorigen Ansprüche, **dadurch gekennzeichnet, dass** die Atmosphäre mindestens eines thermischen Behandlungsschrittes mindestens einen chemischen Stoff aus der Liste He, Ar, $H_2$, $O_2$, $N_2$, $NH_3$, $CH_4$, $SiHCl_3$, $SiH_2Cl_2$, $SiH_4$, $SiCl_4$, $CH_4Cl_2Si$, $H_2O$ enthält.

8. Verfahren nach einem der vorigen Ansprüche, **dadurch gekennzeichnet, dass** der Betrag des radialen thermischen Gradienten sowohl in der Aufheizphase als auch in der Abkühlphase kleiner ist als der Betrag des radialen thermischen Gradienten in der Haltephase.

9. Verfahren nach einem der vorigen Ansprüche, **dadurch gekennzeichnet, dass** für den zweiten thermischen Behandlungsschritt ein Suszeptor verwendet wird, bei dem die Halbleiterscheibe ganzflächig aufliegt.

10. Verfahren nach einem der vorigen Ansprüche, **dadurch gekennzeichnet, dass** die Dauer der Haltephase mindestens 10 s beträgt.

**Claims**

1. Method for evaluating semiconductor wafers, where

   a single-crystal rod of silicon is provided,
   the rod is cut into crystal pieces, and
   a test wafer is removed from one crystal piece,
   where the test wafer is subjected to a first thermal treatment method and
   thereafter a second thermal treatment method is carried out,
   which comprises a heating phase, a holding phase at holding temperature $T_h$, and a cooling phase
   and which causes a radial temperature difference $\Delta T$ between centre and edge on the test wafer,
   and after cooling of the test wafer, the wafer of semiconductor material is analyzed in respect of stress fields, using an SIRD measurement, and the result is utilized to decide whether the semiconductor wafers obtained from the crystal piece are used for component processing or not, where the amount of temperature difference between centre and edge of the test wafer in the holding phase is between 1 K and 30 K.

2. Method according to Claim 1, **characterized in that** the temperature of the holding phase $T_h$ is between 700°C and 1410°C, preferably between 900°C and 1100°C.

3. Method according to either of the preceding claims, **characterized in that** the single-crystal rod is pulled by the Czochralski method.

4. Method according to any of the preceding claims, **characterized in that** the single-crystal rod is pulled by the float zone method.

5. Method according to any of the preceding claims, **characterized in that**

   the heating rate of the heating phase is less than 4 K/s and
   the cooling rate of the cooling phase is less than 5 K/s.

6. Method according to any of the preceding claims, **characterized in that** the amount of the temperature difference between centre and edge of the test wafer in the holding phase is between 2 K and 5 K.

7. Method according to any of the preceding claims, **characterized in that** the atmosphere of at least one thermal treatment step comprises at least one chemical substance from the list consisting of He, Ar, $H_2$, $O_2$, $N_2$, $NH_3$, $CH_4$, $SiHCl_3$, $SiH_2Cl_2$, $SiH_4$, $SiCl_4$, $CH_4Cl_2Si$, and $H_2O$.

8. Method according to any of the preceding claims, **characterized in that** the amount of the radial thermal gradient both in the heating phase and in the cooling phase is smaller than the amount of the radial thermal gradient in the holding phase.

9. Method according to any of the preceding claims, **characterized in that** the second thermal treatment step takes place using a susceptor whereon the semiconductor wafer lies over the whole of its area.

10. Method according to any of the preceding claims, **characterized in that** the duration of the holding phase is at least 10 s.

**Revendications**

1. Procédé d'évaluation de tranches semi-conductrices, une tige monocristalline en silicium étant fournie,

    la tige étant découpée en morceaux de cristal et une tranche de test étant séparée d'un morceau de cristal,
    la tranche de test étant soumise à un premier procédé de traitement thermique et
    puis un deuxième procédé de traitement thermique étant effectué,
    qui comprend une phase de chauffage, une phase de maintien à la température de maintien $T_h$ et une phase de refroidissement
    et qui provoque une différence radiale de température entre le centre et le bord $\Delta T$ sur la tranche de test,
    et, après le refroidissement de la tranche de test, la tranche en matériau semi-conducteur étant examinée quant à la présence de champs de contrainte, une mesure SIRD étant utilisée, et le résultat étant utilisé pour décider si les tranches semi-conductrices obtenues à partir du morceau de cristal sont utilisées ou non pour le procédé de réalisation de composant, la valeur de la différence de température entre le centre et le bord de la tranche de test dans la phase de maintien étant comprise entre 1 K et 30 K.

2. Procédé selon la revendication 1, **caractérisé en ce que** la température de la phase de maintien $T_h$ est comprise entre 700 °C et 1410 °C, de manière préférée entre 900 °C et 1100 °C.

3. Procédé selon l'une des revendications précédentes, **caractérisé en ce que** la tige monocristalline est tirée par le procédé de Czochralski.

4. Procédé selon l'une des revendications précédentes, **caractérisé en ce que** la tige monocristalline est tirée selon le procédé de zone fondue.

5. Procédé selon l'une des revendications précédentes, **caractérisé en ce que**

    la vitesse de chauffage de la phase de chauffage est inférieure à 4 K/s et
    la vitesse de refroidissement de la phase de refroidissement est inférieure à 5 K/s.

6. Procédé selon l'une des revendications précédentes, **caractérisé en ce que** la valeur de la différence de température entre le centre et le bord de la tranche de test dans la phase de maintien est comprise entre 2 K et 5 K.

7. Procédé selon l'une des revendications précédentes, **caractérisé en ce que** l'atmosphère d'au moins une étape de traitement thermique contient au moins une substance chimique de la liste He, Ar, $H_2$, $O_2$, $N_2$, $NH_3$, $CH_4$, $SiHCl_3$, $SiH_2Cl_2$, $SiH_4$, $SiCl_4$, $CH_4Cl_2Si$, $H_2O$.

8. Procédé selon l'une des revendications précédentes, **caractérisé en ce que** la valeur du gradient thermique radial à la fois dans la phase de chauffage et dans la phase de refroidissement est inférieure à la valeur du gradient thermique radial dans la phase de maintien.

9. Procédé selon l'une des revendications précédentes, **caractérisé en ce que** pour la deuxième étape de traitement thermique, un suscepteur est utilisé, dans lequel la tranche semiconductrice repose sur toute la surface.

10. Procédé selon l'une des revendications précéden-

**EP 3 973 090 B1**

tes,
**caractérisé en ce que**
la durée de la phase de maintien est d'au moins 10 s.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2007084827 A1
- US 2004040632 A1
- JP 2015073049 A